# EUROPEAN PATENT APPLICATION

(11) **EP 1 708 262 A2**
(43) Date of publication of application: **04.10.2006**
(21) Application number: 06075616.0
(22) Date of filing: 16.03.2006
(51) Int. Cl.: H01L 23/433

(54) **Thermal conductor and use thereof**

(30) Priority: 30.03.2005 US 93537
(71) Applicant: Delphi Technologies, Inc., Troy, MI 48007 (US)
(72) Inventor: Oberlin, Gary E., Windfall, IN 46076 (US)
(74) Representative: Denton, Michael John

(57) **Abstract**

A thermal conductor (16) suitable for communicating heat from an integrated circuit (14) to a thermal transfer device (18) is disclosed. The thermal conductor (16) comprises a base having a first portion (22) and a second portion (24), wherein the first portion (22) is adapted to be positioned substantially planar to and proximate the integrated circuit (14), and further wherein the second portion (24) includes sidewalls that define an aperture (26) in the body and forms a spherical cavity, and wherein the aperture (26) is adapted to pivotally receive at least a portion of the thermal transfer device (18) such that at least a portion of the thermal transfer device (18) is in thermal communication with the integrated circuit (14).

## Description

### BACKGROUND OF THE NVENTION

Integrated circuits and other electronic devices generate heat when used. Heat dissipation techniques are often employed to prevent the temperature of the electronic devices from exceeding the manufacturer's temperature limit specifications. The life expectancy of electronic devices is significantly shortened if they are operated at temperatures that exceed the manufacturer's specifications. Thus, it is advantageous to transfer heat that is generated from active surfaces of electronic devices away from the devices. In one example, heat may be removed from a junction formed between an integrated circuit electrically attached to a substrate. Integrated circuit is the formal term for a the square of silicon containing a circuit, and the substrate is the surface or board on which the integrated circuits are mounted. The substrate may have multiple layers for the interconnection of the integrated circuits.

To enhance heat transfer away from the integrated circuit, a high efficiency thermal path is conventionally used and thermally attached thereto. One technique for transferring the heat away from the junction is to place the high efficiency thermal path between the junction and a thermal dissipating device, such as a heat sink. Thus, the use of a high efficiency thermal conductor enhances the thermal path for the heat to travel through and subsequently transfer to some other medium, such as air, liquid or other form of material away from the junction. In this manner, the material used to dissipate this heat generally has a substantially high thermal conductivity that is at least sufficient to maintain an acceptable temperature on or across the electronic device.

With advances in integrated circuit technology, such as the exponential growth in the number of transistors fit into a single integrated circuit in semiconductor devices and the like, more heat is generated in a smaller area such that an increase in heat density is produced. Therefore, improvements thermal heat transfer technologies allow the devices to generate increased levels of heat.

### SUMMARY OF THE INVENTION

Accordingly, one embodiment of the invention is directed to a thermal conductor suitable for communicating heat from an integrated circuit to a thermal transfer device. The thermal conductor comprises a base having a first portion and a second portion, wherein the first portion is adapted to be positioned proximate the integrated circuit, and further wherein the second portion includes sidewalls that define an aperture in the body and forms a spherical cavity, and wherein the aperture is adapted to receive at least a portion of the thermal transfer device such that at least a portion of the thermal transfer device is in thermal communication with the integrated circuit

Other systems, methods, features, and advantages of the invention will be or become apparent to one with skill in the art upon examination of the following drawings and detailed description. It is intended that all such additional systems, methods, features, and advantages be included within this description, be within the scope of the invention, and be protected by the accompanying claims.

### BRIEF DESCRIPTION OF THE DRAWINGS

Many aspects of the invention can be better understood with reference to the following drawings. The components in the drawings are not necessarily to scale, emphasis instead being placed upon clearly illustrating the principles of the invention. Moreover, in the drawings, like reference numerals designate corresponding parts throughout several views.
Figure 1 is a side plan view of a thermal transfer system according to an embodiment of the invention;
Figure 2 is a detailed view of a portion of the thermal transfer system according to an embodiment of the invention;
Figure 3 is a side plan view of a thermal transfer system according to another embodiment of the invention;
Figure 4 is a side plan view of a thermal transfer system according to yet another embodiment of the invention;
Figure 5 is another side plan view of a thermal transfer system according to yet another embodiment of the invention; and
Figure 6 is a flowchart illustrating a method according to an embodiment of the invention.

### DESCRIPTION OF THE PREFERRED EMBODIMENT

In the following description, for purposes of explanation, numerous specific details are set forth in order to provide a thorough understanding of the invention, including many options associated therewith. It will be apparent, however, to one skilled in the art that the invention may be practiced without these specific details. Reference in the specification to "one embodiment" or "an embodiment" means that a particular feature, structure, or characteristic described in connection with the embodiment is included in at least one embodiment. The appearance of the phrase "in one embodiment" in various places in the specification are not necessarily all referring to the same embodiment.

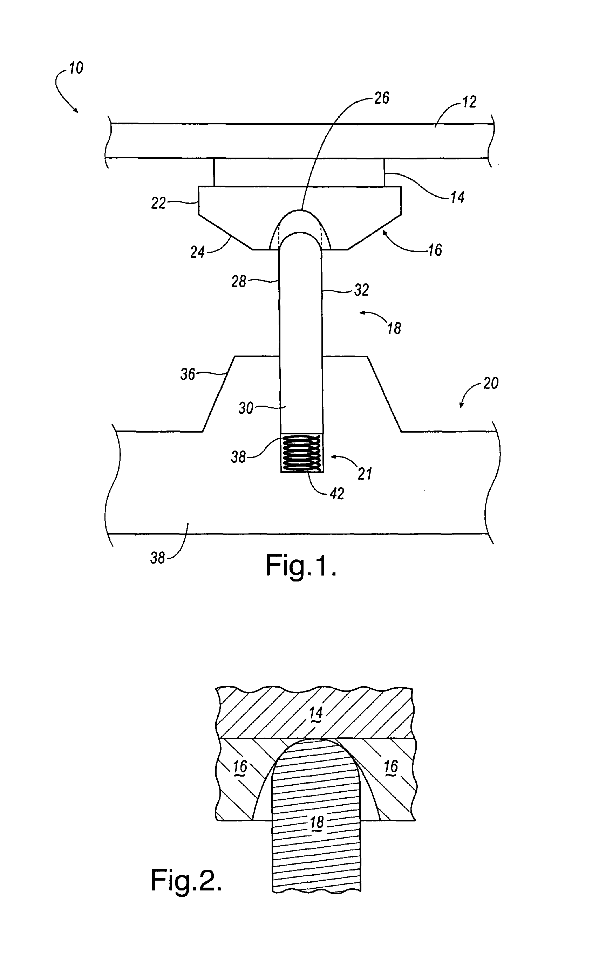

Referring now to Fig. 1, a portion of a thermal transfer assembly 10 is shown and herein described. The thermal transfer assembly 10 includes a substrate 12, an integrated circuit 14, a thermal conductor 16, a thermal transfer device 18, and a thermal dissipating device 20. In an embodiment, a biasing device 21 is further included and is inserted between at least a portion of the thermal transfer device 18 and at least a portion of the thermal dissipating device 20.

The thermal transfer assembly 10 may be used in various types of electronic devices. In one example, the thermal transfer assembly 10 is thermally coupled to a junction formed between the integrated circuit 14 electrically connected to the substrate 12. However, the thermal transfer assembly 10 is not limited to the junction between the substrate 12 and the integrated circuit 14, and, therefore, the thermal transfer assembly 10 may be thermally coupled at any point along the substrate 12 or the integrated circuit 14.

For purposes of the present disclosure, the substrate 12 is a board on which at least one integrated circuit 14 is electrically mounted. The substrate 12 is optionally formed from silicon, ceramic, or the like and is in the form of a multilayered printed board (not shown) on which multiple integrated circuits 14 may be mounted and through which all interconnections therebetween may be made. In an embodiment, the thermal transfer assembly 10 provides a direct thermal path from at least one integrated circuit 14 to the thermal dissipating device 20. It should be noted, that the substrate 12 may instead be made of fiberglass or a combination of materials. One of ordinary skill in the art will recognize the various materials that may be incorporated into the substrate 12. The principles of the thermal transfer assembly 10 may be incorporated into all of such substrates 12.

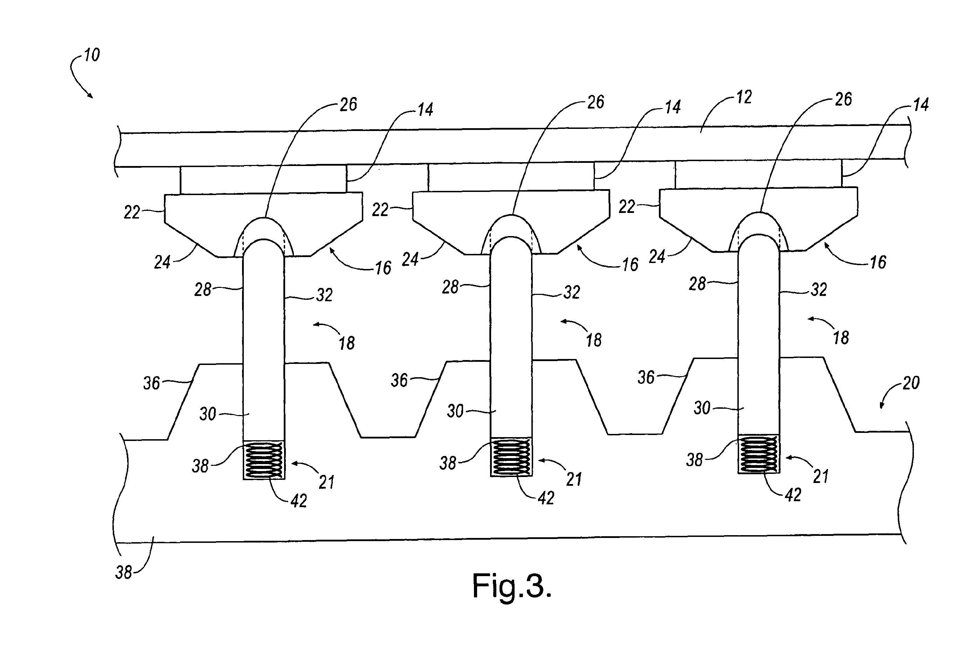

In an embodiment, the integrated circuit 14 is a semiconductor component. The integrated circuit 14 may be electrically mounted to the substrate 12 with solder or using other techniques known in the art. Although Fig. 1 illustrates a single integrated circuit 14 and thermal transfer assembly 10, multiple integrated circuits 14, such as those illustrated in Figs 3-5, in addition to other embodiments of thermal transfer assemblies may, similarly, be implemented in accordance with the invention.

Referring to Figs. 1, 3, and 5 the thermal conductor 16 includes a first region 22 and a second region 24. The first region 22 is proximate to the integrated circuit 14 and the second region 24 is proximate to the thermal transfer device 18. In an embodiment, the thermal conductor 16 extends beyond the integrated circuit 14 in one common dimension. As Fig. 1 illustrates, one way to achieve this is to provide the first region 22 having a side in one dimension that is larger than the perimeter of the integrated circuit 14 in the same dimension. In another example, the first region 22 is larger than the integrated circuit 14 in all dimensions. Fig. 2 highlights the thermal connection between the thermal transfer device 18 and the integrated circuit 14. Although the thermal transfer device 18 appears to physically contact the integrated circuit 14 this is not a necessary feature of the invention. Thus, thermal communication may be achieved both through physical and non-physical contact between the thermal transfer device 18 and the integrated circuit 14. However, physical contact is maintained between the thermal conductor 16 and the thermal transfer device 18.

In an embodiment, the first region 22 maintains a relationship with the integrated circuit 14 using a combination of thermal interface material (not shown) and a biasing force exerted from the thermal transfer device 18 upon the thermal conductor 16. The biasing force originates from the relationship between the biasing device 21, the thermal dissipating device 20 and the thermal transfer device 18. The thermal interface material may be used to eliminate any air gaps that may increase the thermal resistance between the junction. The thermal interface material is generally known and used by those of ordinary skill in the art and will readily recognized by such. It should also be noted that the invention contemplates that the thermal interface material may be used at any region of the thermal transfer assembly 10.

The second region 24 of the thermal conductor 16 includes sidewalls that define an aperture 26. The aperture 26 extends into the first region 22 such that at least a portion of thermal transfer device 18 is thermally coupled with at least a portion of the integrated circuit 14 and the thermal conductor 16 when the thermal transfer assembly 10 is fully constructed. In an embodiment, a first diameter of the aperture 26 is equal to, or larger than, a diameter of the thermal transfer device 18 and tapers down to a second diameter that is still larger than the diameter of the thermal transfer device 18 yet smaller than the first diameter. However, it should be noted, that the first and second diameters of the aperture 26 may be of a uniform size, and further, the uniform diameter may be any size that allows the thermal transfer device 18 entry into the aperture 26 to thermally couple with the integrated circuit 14.

In an embodiment and as shown in phantom in Figs. 1-4, the aperture 26 of the thermal conductor 16 forms a spherical cavity. In this manner, as thermal transfer device 18 is inserted into the spherical cavity, the thermal transfer device 18 is substantially guided thereby. This feature aids in the proper alignment and orientation of the thermal dissipating device 20 with the substrate 12 and substantially eliminates the need to maintain strict tolerances while attaching the thermal dissipating device 20 to the integrated circuit 14 and the substrate 12.

In an embodiment, the thermal transfer device 18 includes a convex spherical end that corresponds with the spherical cavity of the thermal conductor 16 and may be received thereby. This relationship provides a pivot interface between the thermal conductor 16 and the thermal transfer device 18 such that the thermal conductor 16 is guided into substantial planar alignment with the integrated circuit 14 when force is added thereto from the thermal transfer device 18. It is noted that this planar alignment is independent of the orientation of the thermal transfer device 18. That is, bringing the thermal conductor 16 and the integrated circuit 14 into substantial planar alignment substantially minimizes the air gaps that may arise therebetween and increases the thermal transfer efficiency more surface area of the integrated circuit 14 is covered by the thermal conductor 16.

In an embodiment, the thermal transfer device 18 includes an evaporator region 28 and a condenser region 30. As previously discussed, at least a portion of the evaporator region 28 is configured to thermally communicate with at least a portion of the integrated circuit 14 and least a portion of the aperture 26. Also, at least a portion of the evaporator region 28 is spherical to correspond with at least a portion of the spherical cavity of the aperture 26. That is, as the evaporation region 28 of the thermal transfer device 18 contacts the aperture 26, the thermal conductor 16 pivots to substantially maximize its coverage across the integrated circuit 14 so that the integrated circuit 14 and the thermal conductor 16 are substantially planar. This relationship not only substantially correctly aligns the thermal dissipating device 20 with the integrated circuit 14 and the substrate 12, but also substantially aligns the thermal conductor 16 with the integrated circuit 14.

For example, when even a small degree of pressure is applied to the thermal transfer device 18 and the thermal conductor 16 (e.g. by way of substrate 12 and/or thermal dissipating device 20) the spherical engagement between the thermal transfer device 18 and the spherical cavity formed within aperture 26 may result in movement of one of the substrate 12, the thermal dissipating device 20, or both so that they are substantially brought into alignment if they are not already aligned. The substantial alignment of these structures also helps to substantially ensure that the thermal communication between the integrated circuit 14 and the thermal conductor 16 is additionally substantially planar therebetween.

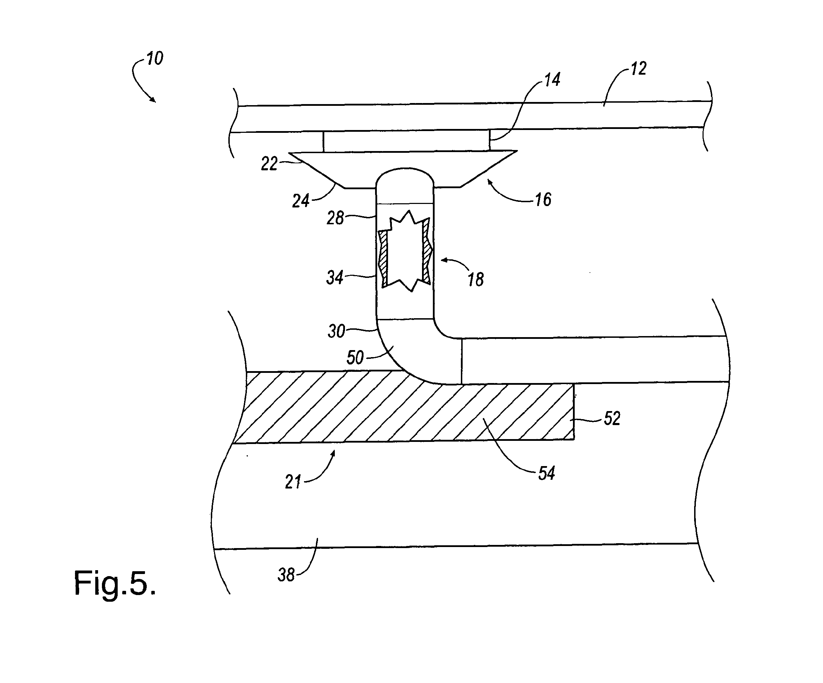

In an embodiment and as represented in Figs. 1-3, the thermal transfer device 18 is a thermally conductive pin 32. In another embodiment and as represented in Fig. 5, thermal transfer device 18 is a thermally conductive pipe 34. In one embodiment the thermally conductive pin 32 and the thermally conductive pipe 34 are solid. However, the thermally conductive pin 34 and the thermally conductive pipe 34 may instead be a tubular device having a hollow inner portion that holds a liquid such as water, or acetone in a vacuum. In one embodiment, an inner surface of the thermal pipe 34 is lined with a porous material that acts as a wick. When heat is applied to the outer surface of the thermal pipe 34, the liquid inside the tube boils and vaporizes into a gas that moves through the tube seeking a cooler location where it condenses. Using capillary action, the wick transports the condensed liquid back to the evaporation area. One of ordinary skill in the art will recognize other similar structures, which will become readily recognizable when considering the present disclosure. In this manner, the features and concepts of the invention are to be incorporated into such structures.

With continued reference to Fig. 1, thermal dissipating device 20 is fabricated from aluminum. Aluminum is used as it has good thermal conducting properties. It should be noted, however, that other types of materials having a high degree of thermal conductivity may alternatively be used and the invention should not be limited to such. Also, well known thermally conductive plating can be placed on the surface of the thermal transfer device 18, or thermal conduct 16 to enhance thermal conductivity therebetween.

In an embodiment, thermal dissipating device 20 includes a base portion 36 having at least two pedestals 36 that define an aperture 38 therebetween. The aperture 38 is adapted to receive at least a portion of the condenser region 30 of the thermal transfer device 18. As previously discussed, thermal interface material may be disposed at least between thermal transfer device 18 and aperture 38 as there is often a large number of microscopic gaps. The thermal interface material may also provide a lubricous interface between the pedestals 36 and the thermal transfer device 18. The thermal interface material the two surfaces transfer heat between two structures more effectively.

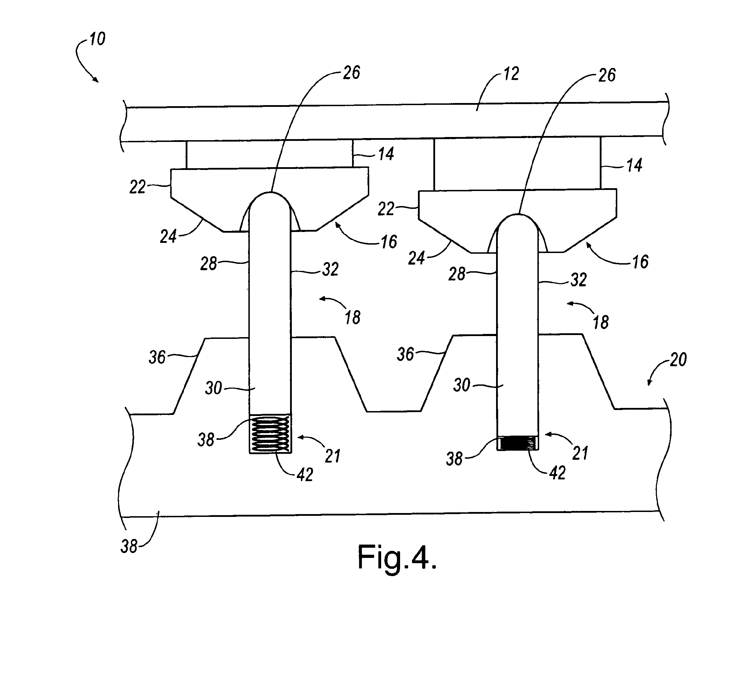

In an embodiment, a biasing device 21 is integrated between the condenser region 30 of thermal transfer device 18 and a floor 40 of aperture 38. Biasing device 21 maintains pressure between evaporator end 28 of thermal transfer device 18 and aperture 26 of thermal conductor 16. In this manner, and as illustrated in Fig. 4, the biasing device 21 at least compensates for any elevation variation of the thermal assembly 10 and substantially ensures a planar relationship between the integrated circuit 14 and the thermal conductor 16. The biasing device 21 also prevents overstressing of integrated circuit 14 if too much pressure is applied along any point of the thermal dissipating device 20 or the substrate 12 and the integrated circuit 14. As previously mentioned above, a lubricous interface is applied between aperture 38 and thermal transfer device 18 to at least provide a sliding relationship therebetween so that the biasing device 21 may effectively control the pressure.

In an embodiment, biasing device 21 is a coil spring 42. In another embodiment, biasing device is an elastomeric material. The feature and advantages of each will be further discussed hereinbelow.

With reference now to Fig. 3, a side plan view of a thermal transfer assembly 10 is shown according to another embodiment of the invention. Fig. 3 illustrates the thermal transfer assembly 10 incorporating three integrated circuits 14 and three thermal pins 32 into a common base 38 of the thermal dissipating device 20. The thermal dissipating device 20 further includes multiple pedestals 36 that define three apertures 36 for the thermal pins. In the illustration, each of the integrated circuits 14 are at the same elevation, and, therefore, the biasing device 21 that is proximate to each of the condenser ends 30, yields a similar compression thereon.

Fig. 4 illustrates a side plan view of a thermal transfer assembly 10 according to yet another embodiment of the invention. In accordance with the principles of the invention, the thermal transfer assembly 10 is shown incorporating two integrated circuits 14. Each of the integrated circuits 14 are at different elevations. In this manner, the biasing device 21 proximate the condenser end 30 of each thermal pin 32 yields a different compression to therefore equalize the pressure on each of the corresponding integrated circuits 14. This feature highlights the ability of the invention to adjust for variant elevation integrated circuits 14.

Referring now to Fig. 5, a side plan view of a thermal transfer assembly 10 according to yet another embodiment of the invention is shown and herein described. In Fig. 5 and as previously mentioned, the thermal transfer device 18 is a thermal pipe 34. The thermal pipe 34 includes side walls that form a longitudinal center opening that extends along the length of the pipe 34. The condenser end 30 of the thermal pipe 34 forms an elbow 50 that rests on a portion of thermal dissipating device 20. In this embodiment, the thermal dissipating device 20 includes a receiving portion 52. In this manner, the receiving portion 52 forms a receptacle for the elbow 52. The biasing device 21 is integrated or disposed in the receiving portion 52. The elbow 50 of the thermal pipe 34 contacts the biasing device 21 so that sufficient force is added between the evaporator end 28 of the thermal pipe 34 and the aperture 26 of the thermal conductor 16. In this embodiment, the biasing device 21 is a flexible elastomeric material 54. It should be noted that multiple thermal pipes 34 such as the one herein described may also be incorporated into Fig. 5. Also, as in Fig. 4, the inclusion of the elastomeric material 54 provides that multiple integrated circuit elevations may be included and will not be adversely affected by the elevation as the invention. Similarly, this substantially eliminates the traditional concern involved with conventional overstressing

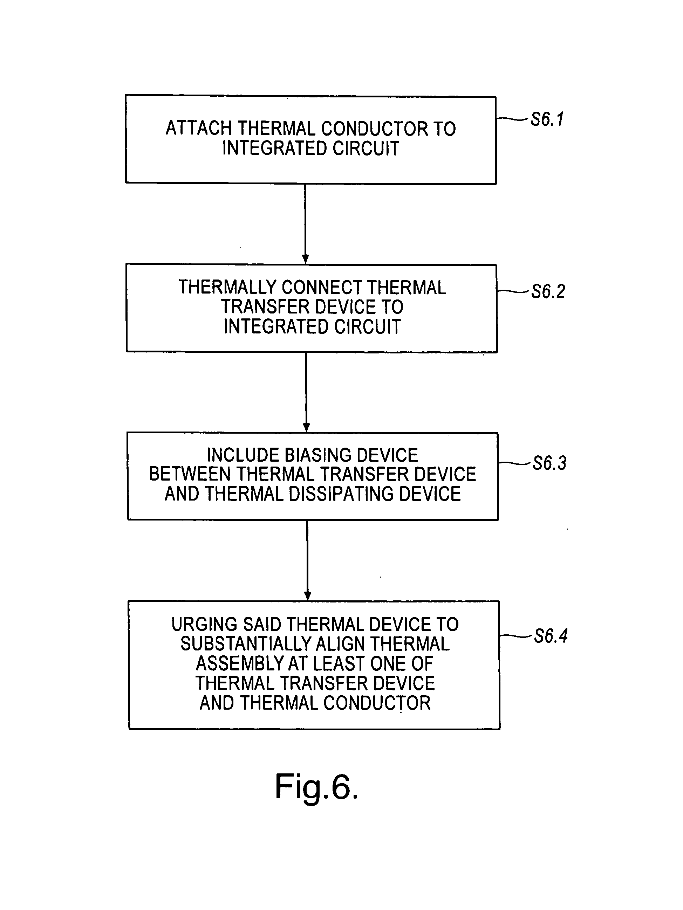

Referring now to Fig. 6, a method for manufacturing a thermal transfer assembly 10 is shown and described. Preliminarily, the thermal junction includes a substrate and an integrated circuit connected thereto. Step S6.1 illustrates that a thermal conductor is attached to the integrated circuit, wherein the thermal conductor is larger than the integrated circuit in at least one dimension. Step S6.2 illustrates that an end of a thermal transfer device is inserted into an aperture of the thermal conductor such that a portion of the end is in thermal communication with the integrated circuit. Next, a biasing device is disposed between the thermal transfer device and a thermal dissipating device connected thereto such that a small amount of force is applied between the thermal transfer device and the thermal conductor in step S6.3. Finally, the force from the at least one biasing device urges the thermal conductor to become substantially planar with the integrated circuit such that the surfaces thereof are substantially aligned in step S6.4 while not overstressing the integrated circuit 14.

It should be emphasized that the above-described embodiments of the invention, particularly, any "preferred" embodiments, are only possible examples of implementations, merely set forth for a clear understanding of the principles of the invention. Many variations and modifications may be made to the above-described embodiment(s) of the invention without departing substantially from the spirit and principles of the invention. All such modifications and variations are intended to be included herein within the scope of this disclosure and the invention and protected by the following claims.

## Claims

1. A thermal conductor (16) suitable for communicating heat from an integrated circuit (14) to a thermal transfer device (18), said thermal conductor (16) comprising:
a base having a first portion (22) and a second portion (24),
wherein said first portion (22) is adapted to be positioned substantially planar to and proximate the integrated circuit (14), and
further wherein the second portion (24) includes sidewalls that define a spherical cavity in said base, and wherein the spherical cavity (26) is adapted to pivotally receive at least a portion of the thermal transfer device (18) such that at least a portion of the thermal transfer device (18) is in thermal communication with the integrated circuit (14).

2. The thermal conductor (16) from claim 1, wherein said first portion (22) of said base has a first dimension that is larger than a common dimension of said integrated circuit (14).

3. The thermal conductor (16) from claim 1, wherein said first portion (22) of said is larger than said integrated circuit (14) in all dimensions.

4. The thermal conductor (16) from claim 1, wherein said thermal conductor is in pivotal communication with said thermal conductor (16) such that said thermal conductor (16) substantially planarly aligns with said integrated circuit (14) independent of a position of said thermal transfer device (18).

5. The thermal conductor from claim 1, wherein said spherical cavity (26) of said second portion (24) and an end (28) of the thermal transfer device (18) respectively define female and male thermally mating spherical interfaces.

6. The thermal conductor (16) from claim 5, wherein said aperture (26) and the end (28) of the thermal transfer device (18) are adapted to urge said thermal conductor (16) and said integrated circuit (14) to planarly align.

7. A thermal transfer assembly (10) comprising:
a substrate (12);
at least one integrated circuit (14) attached to said substrate (12), said at least one integrated circuit (14) having a first dimension and a second dimension forming a perimeter; and
at least one thermal conductor (16) attached to each of said at least one integrated circuit (14), wherein said at least one thermal conductor (16) has a fist dimension and a second dimension forming a perimeter,
wherein at least one of said dimensions of said at least one thermal conductor (16) is larger than the corresponding dimension of said at least one integrated circuit (14).

8. The thermal transfer assembly (10) from claim 7, wherein both dimensions of said at least one thermal conductor (16) are larger than both dimensions of said at least one integrated circuit (14) such that the perimeter of said thermal conductor (16) is greater than the perimeter of said integrated circuit (14).

9. The thermal transfer assembly (10) from claim 7, further comprising at least one thermal transfer device (18) having first and second ends (28, 30), wherein said first end (28) is at least in thermal communication with said at least one thermal conductor (16) and said integrated circuit (14).

10. The thermal transfer assembly from claim 7, further comprising:
a base (38) having pedestals (36) that define an aperture (42), wherein said second end (30) of said thermal transfer device (18) is received by said aperture (42) and is in slidable communication therewith.

11. The thermal transfer assembly (10) from claim 10, further comprising:
at least one biasing device (21) between said second end (30) of said thermal transfer device (18) and said base (38) such that said at least one biasing device (21) is at least adapted to urge said first end (28) of said thermal transfer device (18) to thermally communicate with said integrated circuit.

12. The thermal transfer assembly (10) from claim 11, wherein said aperture (26) of said thermal conductor (16) and said first end (28) of said thermal transfer device (18) form corresponding spherical structures, and further wherein said corresponding spherical structures are adapted to urge said integrated circuit (14) and said thermal conductor (16) to substantially planarly align.

13. The thermal transfer assembly (10) from claim 11, wherein said thermal transfer device (18) is a thermal pin.

14. The thermal transfer assembly (10) from claim 11, wherein said at least one biasing device (21) is a spring.

15. The thermal transfer assembly (10) from claim 11, wherein said thermal conductor (16) includes sidewalls that define an aperture (26), and further wherein said aperture (26) and said first end (28) of said thermal transfer device (18) respectively define female and male thermally mating spherical interfaces whereby the thermal transfer device (18) pivotally communicates with the thermal conductor (16) such that the thermal conductor (16) substantially planarly aligns with the integrated circuit (14) independent of a position of the thermal conductor (16).

16. A method for manufacturing a device for dissipating heat in a thermal junction, the thermal junction including a substrate (12) and an integrated circuit (14) electrically connected thereto, said method comprising the steps of:
attaching a thermal conductor (16) to the integrated circuit (14),
wherein the thermal conductor (16) includes a dimension larger than a common dimension of the integrated circuit (14);
thermally connecting a thermal transfer device (18) to the integrated circuit (14);
biasing said thermal device (21) such that force is exerted between said thermal transfer device (18) and said thermal conductor (16); and
urging said thermal transfer device (18) in said aperture (26) such that the thermal conductor (16) and the integrated circuit (14) substantially planarly align.

17. The method for dissipating heat from claim 16, further comprising the step of:
pivoting the thermal conductor (16) on an end (28) of said thermal transfer device (18) such that the thermal conductor (16) and the integrated circuit (14) substantially planarly align.

18. The method for dissipating heat from claim 16, further comprising the step of:
disposing thermal interface material between said integrated circuit (14) and said thermal conductor (16).

19. The method for dissipating heat from claim 16, further comprising the step of:
disposing thermal interface material between said substrate (12) and said integrated circuit (14).

20. The method for dissipating heat from claim 16, further comprising the step of:
soldering the integrated circuit (14) to the substrate (12).

21. The method for dissipating heat from claim 16, further comprising the step of:
transferring heat to a pedestal (36) connected to an end of the thermal transfer device (18).
